# EUROPEAN PATENT APPLICATION

(11) **EP 1 399 005 A2**
(43) Date of publication of application: **17.03.2004**
(21) Application number: 03017439.5
(22) Date of filing: 01.08.2003
(51) Int. Cl.: H05K 1/11

(54) **Housing preform and electronic apparatus using the same**

(30) Priority: 05.08.2002 JP 2002227042
(71) Applicant: SHINKO ELECTRIC INDUSTRIES CO. LTD., Nagano-shi, Nagano 380-0921 (JP)
(72) Inventor: Miyagawa, Fumio, Shinko Electric Indust. Co., Ltd., Nagano-shi, Nagano 380-0921 (JP)
(74) Representative: Patentanwälte Ruff, Wilhelm, Beier, Dauster & Partner

(57) **Abstract**

A housing preform consisting of a plate member formed to be bendable in which are formed electronic components (22) and an interconnect (24) electrically connecting the electronic components. The plate member is formed into a shape of the housing unfolded flat. The housing can be formed by folding the plate member. Due to this, it is possible to provide an electronic apparatus comprised of a housing in which electronic components are mounted.

## Description

### BACKGROUND OF THE INVENTION

### 1. Field of the Invention

The present invention relates to a housing preform and an electronic apparatus using the same, more particularly relates to a housing preform for forming a housing mounting a semiconductor chip or other electronic components or an electronic apparatus formed by that housing preform.

### 2. Description of the Related Art

An electronic apparatus mounting a semiconductor chip or other electronic components is generally comprised of a housing inside of which the electronic components are housed. For example, when mounting a semiconductor chip or other electronic components in an electronic apparatus, the general method used in the past has been to assemble the semiconductor chip and other electronic components, mount them on a mounting board etc., and place the mounting board etc. in the housing to thereby complete the electronic apparatus. Therefore, various proposals have been made about the structure of a package for mounting semiconductor devices, the method of mounting a semiconductor chip on a mounting board, the method of assembling and mounting electronic components, etc.

The method of mounting electronic components in a housing to form an electronic apparatus is suitable for mass production since easy to mass produce, general use parts can be used, but it is not possible to handle the production of more specialized products or products of a new type not seen in the past or the production of a product provided with new functions by the conventional method of assembling a circuit module in a housing. Of course, as a circuit module having a complicated function specialized in accordance with the product, there is a circuit module consisting of a combination of semiconductor devices, resistors, capacitors, or other circuit components. Products obtained by embedding semiconductor devices in a board or assembling circuit parts together with semiconductor devices using a plurality of boards are also being provided.

However, when trying to handle more diverse types of electronic apparatuses, there are limits to the combination of electronic components by the conventional method of assembling electronic components in a housing.

### SUMMARY OF THE INVENTION

An object of the present invention is to provide a housing preform for realizing a novel structure (system) for mounting electronic components by a method fundamentally different from the prior art of assembling electronic components in such a housing and an electronic apparatus using the same.

To attain the above object, there is provided a housing preform comprised of a bendable plate member inside of which is formed electronic components and interconnects for electrically connecting the electronic components.

Preferably, the plate member is comprised of a pliable substrate and a pliable protective film burying and covering the electronic components.

Parts of the plate member to be bent are preferably provided with reinforcements for preventing breakage of the interconnects. As such reinforcements, metal wires etc. are effective.

The interconnects are preferably formed by conductive paste. Interconnects formed by conductive paste are superior in flexibility, so can be easily deformed at the time of bending the housing preform and therefore breakages can be prevented.

The plate member is preferably of the shape of the housing unfolded flat. Due to this, formation of a housing using the housing preform becomes easy.

According to a second aspect of the invention, there is provided an electronic apparatus having a 3D housing comprised of a bent housing preform of the first aspect of the invention.

According to a third aspect of the invention, there is provided an electronic apparatus comprised of a combination of a housing preform of the first aspect of the invention and system components.

### BRIEF DESCRIPTION OF THE DRAWINGS

These and other objects and features of the present invention will become clearer from the following description of the preferred embodiments given with reference to the attached drawings, wherein:
FIG. 1 is a perspective view showing the concept of a mounting structure of electronic components according to the present invention;
FIG. 2 is a plan view of a housing preform for assembling a housing shown in FIG. 1;
FIGS. 3A and 3B are sectional views of a method of forming a housing preform;
FIGS. 4A and 4B are a plan view and a sectional view of the configuration of a bending position of a housing preform;
FIGS. 5A and 5B are a plan view and a sectional view of a method for forming a large number of housing preforms;
FIG. 6 is a sectional view of an example of formation of a curved housing using a housing preform;
FIGS. 7A, 7B, and 7C are perspective views of an example of formation of a housing using a housing preform;
FIGS. 8A and 8B are perspective views of an example of formation of a housing using a housing preform;
FIGS. 9A and 9B are sectional views of an example of application of a mounting structure of electronic components according to the present invention; and
FIGS. 10A, 10B, and 10C are sectional views and a plan view of an example of fabrication of a capsule camera using a housing preform according to the present invention.

### DESCRIPTION OF THE PREFERRED EMBODIMENTS

Preferred embodiments of the present invention will be described in detail below while referring to the attached figures.

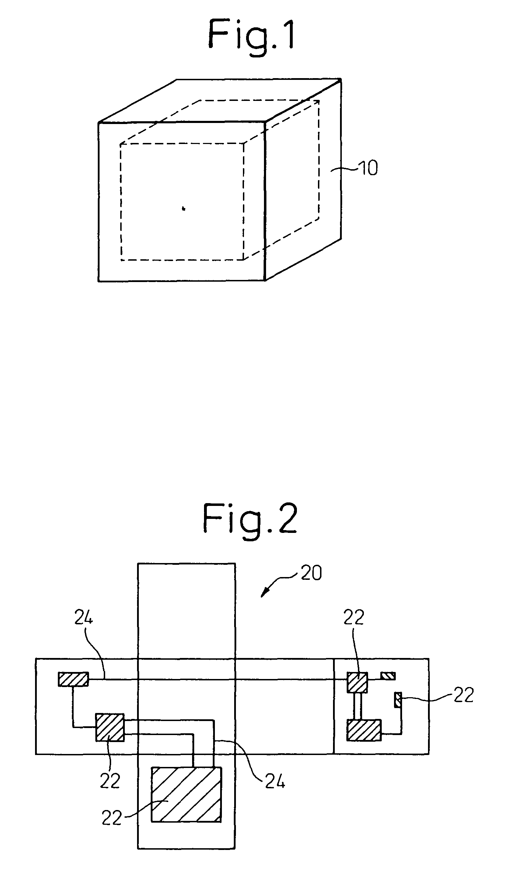

FIG. 1 is a view for explaining the basic concept of a housing preform according to the present invention and an electronic apparatus using the same. The housing comprised of the housing preform according to the present invention uses the housing 10 itself as a circuit region. In a conventional electronic apparatus, the semiconductor chip and other electronic components are accommodated at the space inside the housing, but in the electronic apparatus according to the present invention, the electronic components are mounted at the housing 10 itself, not at the space inside the housing 10.

The housing 10 of the present invention is obtained by bending or assembling (plastic working) a housing preform using a housing preform having bendability or pliability to form a 3D housing 10. FIG. 2 is a plan view of a housing preform for assembling a housing 10 shown in FIG. 1. The housing 10 shown in FIG. 1 forms a 3D shape externally. The housing preform 20 for forming this housing is formed to the shape of the housing 10 unfolded as shown in FIG. 2.

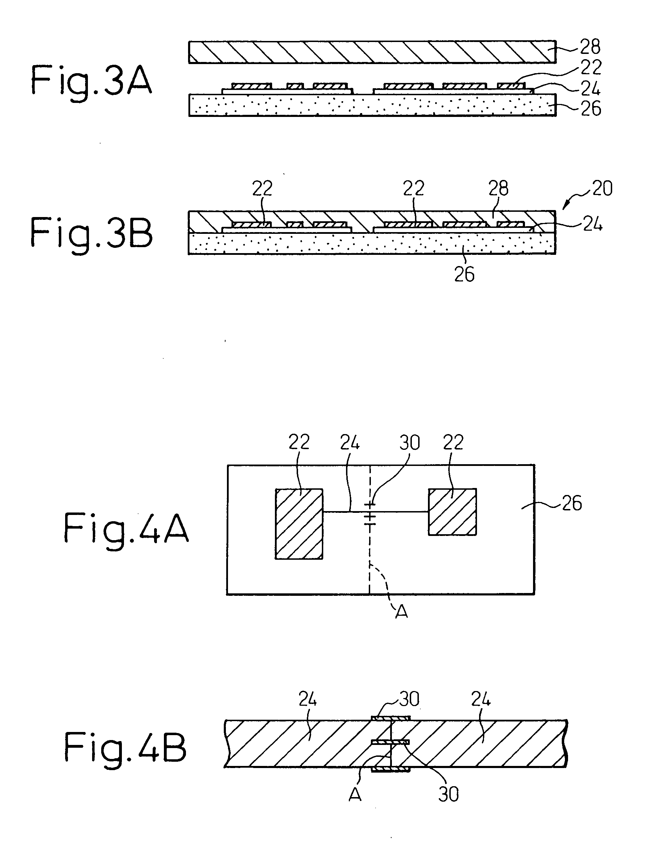

Reference numeral 22 is an electronic component mounted at the housing preform 20, while 24 is an interconnect for electrically connecting an electronic component 22. FIGS. 3A and 3B show an example of formation of the housing preform 20 mounting the electronic components 22. FIG. 3A shows the state of mounting electronic components 22 on a substrate 22 and laminating the surface of the substrate 26 mounting the electronic components 22 by a protective film 28 made of a plastic, while FIG. 3B shows the state where the electronic components 22 mounted on the substrate 26 are covered by the protective film 28 so as to be buried inside the protective film 28. The substrate 26 and the protective film 28 both have pliability. The substrate 26 and the protective film 28 form a plate member housing the electronic components 22. Note that the protective film 28 is preferably made using a thermoplastic film.

The substrate 26 forming the housing preform 20 can be made using any material such as a metal, plastic, or paper. FIGS. 3A and 3B show the use of paper for the substrate 26, mounting the electronic components 22 on the substrate 26, and covering the electronic components 22 by a protective film 28. Since the plate member has pliability, the housing preform 20 also has pliability and it is possible to bend the housing preform 20 to form a housing of a suitable shape. For example, to get the paper to be exposed at the outside surface of the housing 10, it is sufficient to do this when bending the housing preform 20. Note that the plate member is not limited to one of a substrate 26 and a protective film 28 made of different materials. These may be formed by the same material.

As shown in FIG. 2, the operation of bending the housing preform 20 of the shape of a 3D object unfolded to form a housing means "plastic working" in this specification. As the method for enabling reliable connection of the interconnects 24 at the bending positions when bending the housing preform 20 to a 3D shape, as shown in FIGS. 4A and 4B, it is sufficient to provide metal wires 30 as reinforcements near where the interconnects 24 are formed or inside the interconnects 24. When forming the interconnects 24 on the substrate 26, it is possible to bury metal wires 30 at the positions forming the interconnects 24 or near the interconnects 24.

As the method for forming interconnects 24 on the surface of a substrate 26, the method of printing interconnects 24 on the surface of the substrate 26, the method of using a substrate 26 covered on its surface with copper foil and forming interconnects 24 by etching the copper foil, the method of forming a film by sputtering or plating etc. to form interconnects 24, the method of forming conductive paste by coating by a dispenser in patterns of the interconnects 24, etc. may be utilized. When burying metal wires 30 such as shown in FIGS. 4A and 4B, it is possible to bury them when forming patterns of interconnects 24 by printing etc. or before and after plating.

Note that when using conductive paste to form interconnects 24, there is the advantage that the interconnects 24 have flexability, so breakage does not easily occur when bending the housing preform 20 to form the housing. Further, when using conductive paste to form interconnects 24, the interconnects are formed by coating conductive paste by a dispenser, so there are the advantages that it is possible to easily form interconnects in a 3D arrangement and possible to form interconnects in any patterns by dispensing conductive paste in a state with the electronic components 22 mounted on the substrate 26.

Note that the "conductive paste" is comprised of conductive paste of gold, silver, or copper dispersed in a dispersant to form a paste. A conductive paste using conductive particles of a particle size of less than 100 nanometers (nanolevel) is particularly referred to as a "fine conductive paste". When using metal particles reduced in size to the nanolevel, sintering occurs at a far lower temperature than the inherent melting point of the metal. For example, when using nickel particles of a size of about 10 nanometers as the conductive particles, the nickel particles aggregate and join by just heating to about 100°C to 200°C. Therefore, there are the advantages that it is possible to form electric conductors without heating to too high a temperature and possible to form interconnects 24 without damaging the electronic components 22 or substrate 26. Further, there are the advantages that the conductors formed using the fine conductive paste have smaller electrical resistances and interconnects 24 superior in electrical characteristics can be obtained.

When using fine conductive paste to form interconnects 24, it is possible to form finer patterns compared with when using the conventional conductive paste. This can be particularly effectively used when it is necessary to form fine interconnects, when forming extremely small housings, and when requiring to form interconnects at a high density. When using fine conductive paste to form interconnects, the method of ink jet printing or the method of coating using a dispenser can be used. By supporting the housing preform 20 on an X-Y table, it is possible to form interconnects 24 in any patterns.

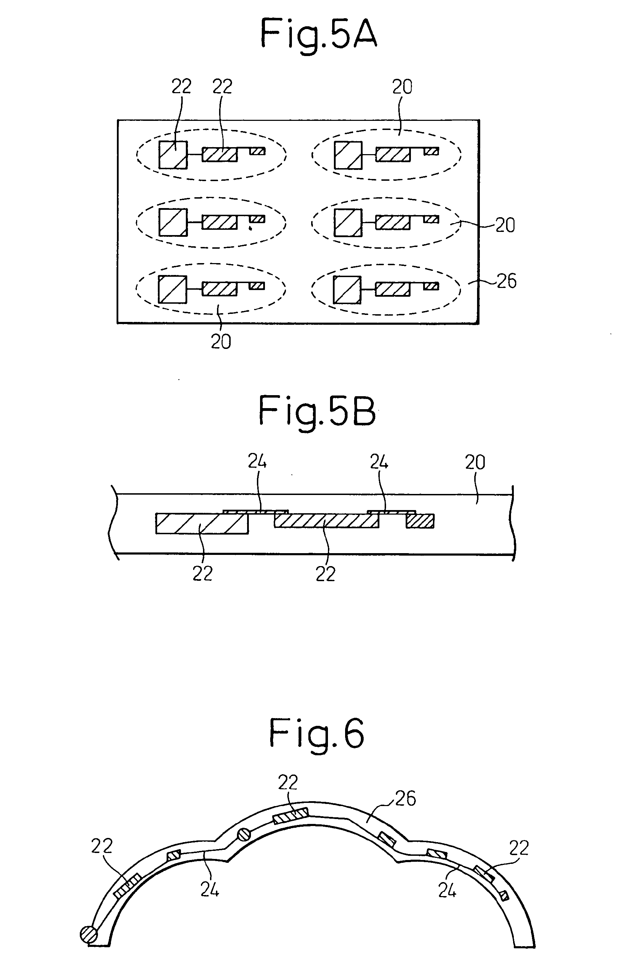

The housing preform 20 can be formed into a suitable shape in accordance with the shape of the housing 10. FIGS. 5A and 5B show an example of obtaining a large number of housing preforms 20. The master substrate 26 is provided with electronic components 22 in predetermined repeated arrays. For example, it is possible to punch sections out into elliptical shapes to form the housing preforms 20 (FIG. 5A). FIG. 5B shows the state of connecting the electronic components 22 by interconnects 24 in the individual housing preforms 20. The individual housing preforms 20 may be bent into predetermined shapes to obtain the required housing shapes.

FIG. 6 is an example of formation of a housing having a curved outer shape obtained by bending the housing preform 20 into curves. Even in the case of a housing provided with such a curved outer shape, it is possible to use interconnects 24 to electrically connect and mount electronic components 22 in the housing itself and possible to provide a housing which itself is provided with a specific function.

The curved housing shown in FIG. 6 can be applied to for example the housing of a robot. If applied to a wristwatch type mobile phone, reduction of the thickness and weight becomes possible. Note that the plastic working of a curved shape and elastic deformation due to heat fluctuations are accompanied with anistrophy. To prevent breakage of interconnects, it is possible that the interconnects can track such anistropic expansion and contraction. From this viewpoint, the present inventors confirmed that if mixing several percent of carbon nanotubes or carbon nanowires into fine conductive paste to form the interconnects 24, interconnects with high elasticity can be obtained. The reason why such an effect can be obtained is still unknown, but carbon nanotubes or carbon nanowires have recently been commercialized, so this is extremely useful as a method of forming interconnects with a high elastic deformability and resistance to breakage.

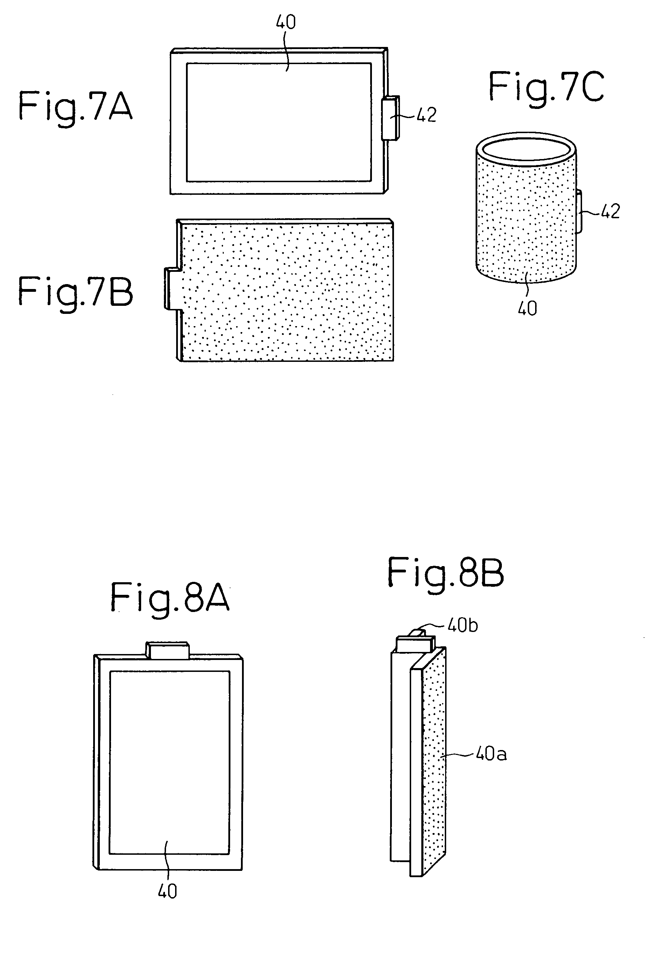

FIGS. 7A, 7B, 8A, and 8B show an electronic apparatus formed using a housing preform according to the present invention. FIGS. 7A to 7C are a front view and back view of a panel member 40, while FIG. 7C is an assembled view. FIG. 7C shows a hook 42 provided at the end of a panel member 40 engaged with the other end of the panel member 40 to form a tubular electronic apparatus. FIG. 8B shows an example of use of the panel member 40 bent in a Z-shape. The panel member 40 has pliability, so can be formed into a suitable shape by such a bending operation.

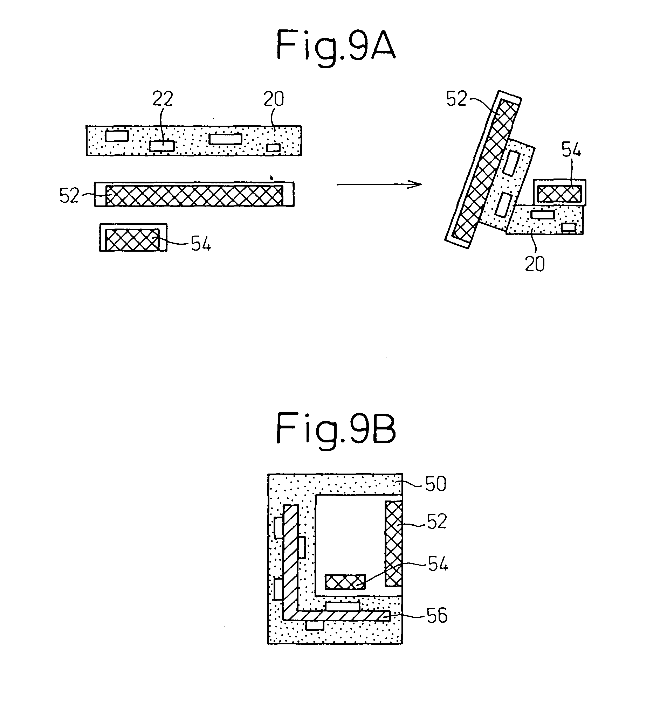

FIGS. 9A and 9B show still another example of an electronic apparatus using a housing preform 20. As shown in FIG. 9B, if applying the housing preform 20 according to the present invention to a conventional product of a type housing a display 52, disk drive 54, and board 56 inside a housing 50, it is possible to form system components comprised of the housing preform 20, display 52, and disk drive 54 shown in FIG. 9A and possible to combine system components to form an electronic apparatus. Since the housing preform 20 has bendability, there are the advantages that the operation for deforming the shape becomes easy, system components may be combined in any way, and the arrangement can be suitably adjusted. If using the functions unique to this housing preform 20, application to very diverse products becomes possible. It is also possible to provide an electronic apparatus having new functions not seen in the past.

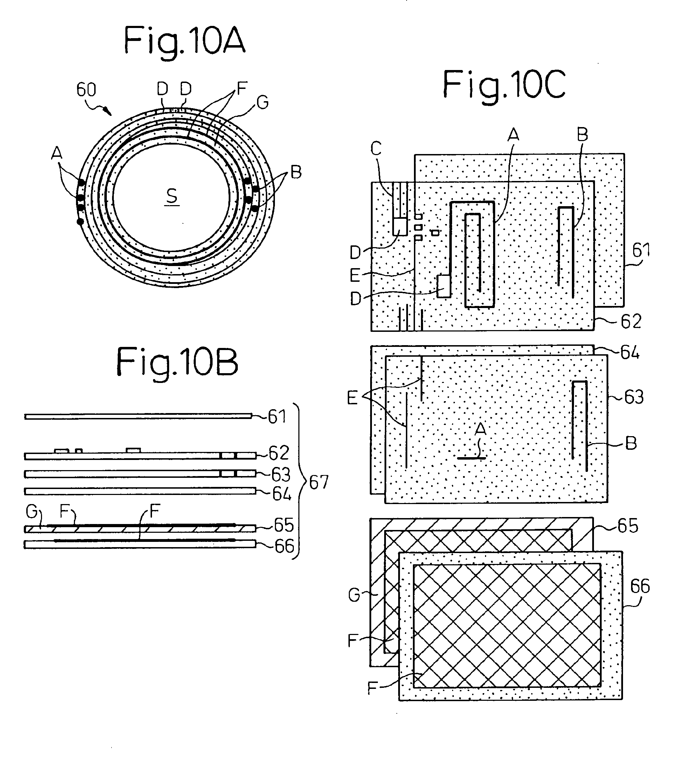

FIGS. 10A, 10B, and 10C show application of the housing preform of the present invention to a capsule camera. The capsule camera 60 shown in FIG. 10A is a tubular shape obtained by superposing and rolling up a large number of sheet-shaped housing preforms according to the present invention. The tubular solid part surrounding the center space S is provided with a communication control antenna A, a power feed antenna (electromagnetic coil) B, electronic components (D), etc. embedded in it. It is also possible to form a capacitor using a single conductive sheet F to sandwich a dielectric layer G. The space S may house a camera optical part, active ingredient, pump, etc.

FIG. 10B shows the state of the tubular solid part of FIG. 10A unfolded. The tube is formed by superposing and rolling up six sheets 61 to 66.

The sheet 61 is a pliable protective film, the sheet 62 is a pliable substrate formed with a communication control antenna A, a power feed antenna B, a connector C, electronic components D, and interconnects E, the sheet 63 is a pliable substrate formed with thick parts of the antennas A and B and the interconnects E, the sheet 64 is a pliable protective film, the sheet 65 is a dielectric film G formed with an electrode layer F, and the sheet 66 is a pliable substrate 66 formed with an electrode layer F.

By laminating the sheets 61 to 66 of FIG. 10C as shown in FIG. 10B, the housing preform 67 of the present invention is obtained. By rolling this up, a capsule camera 60 of FIG. 10A is completed.

While the final assembly is not shown, an optical head and pump tail are attached to the two ends of the tube and the tube sealed.

In this way, as an advantage according to the present invention, components and circuits are formed together with the housing after planar mounting, so there is more space S in the capsule compared with the case of assembly in a space surrounded by the housing as in the past.

According to the housing preform of the present invention, as explained above, there is a large degree of freedom of the shape of the housing preform, so use for extremely diverse products becomes possible. Further, programmable mounting technology can be utilized. Therefore, there is the remarkable effect that a novel electronic apparatus never seen in the past can be provided.

While the invention has been described with reference to specific embodiments chosen for purpose of illustration, it should be apparent that numerous modifications could be made thereto by those skilled in the art without departing from the basic concept and scope of the invention.

## Claims

1. A housing preform comprised of a bendable plate member inside of which is formed electronic components and interconnects for electrically connecting said electronic components.

2. A housing preform as set forth in claim 1, wherein said plate member is comprised of a flexible substrate and a flexible protective film burying and covering said electronic components.

3. A housing preform as set forth in claim 1 or 2, wherein parts of said plate member scheduled to be bent are provided with reinforcements for preventing breakage of said interconnects.

4. A housing preform as set forth in any of the preceding claims, wherein said interconnects are formed by conductive paste.

5. A housing preform as set forth in any of the preceding claims, wherein said plate member is of the shape of the housing unfolded flat.

6. An electronic apparatus having a 3D housing comprised of a bent housing preform as set forth in any of claims 1 to 5.

7. An electronic apparatus comprised of a combination of a housing preform as set forth in any of claims 1 to 5 and system components.
